# EUROPÄISCHE PATENTSCHRIFT

(11) **EP 0 355 559 B1**
(45) Veröffentlichungstag und Bekanntmachung des Hinweises auf die Patenterteilung: **14.04.1993**
(21) Anmeldenummer: 89114592.2
(22) Anmeldetag: 07.08.1989
(51) Int. Cl.: G01R 35/04

(54) **Schaltungsanordnung für die Kontrolle und Überwachung der Funktion eines elektronischen Elektrizitätszählers**
Monitoring circuitry for an electronic electricity counter
Circuit de surveillance d'un compteur d'électricité électronique

(30) Priorität: 19.08.1988 DE 3828273
(43) Veröffentlichungstag der Anmeldung: 28.02.1990
(73) Patentinhaber: SIEMENS AKTIENGESELLSCHAFT, 80333 München (DE)
(72) Erfinder: Förder, Walter, Dipl.-Phys., D-8510 Fürth (DE); Schwendtner, Manfred, Dipl.-Ing., D-8501 Schwarenbruck (DE); Fuchs, Gerhard, Dipl.-Phys., D-8510 Fürth (DE); Steinmüller, Günter, Dipl.-Ing. (FH), D-8500 Nürnberg (DE)

(56) Entgegenhaltungen:
- EP-A- 0 240 102
- DE-A- 2 653 898
- GB-A- 2 075 204
- GB-A- 2 099 596
- US-A- 3 708 791
- PATENT ABSTRACTS OF JAPAN, Band 6, Nr. 141 (P-131)[1019], 30. Juli 1982; & JP-A-57 63 461 (NIHON DENKI KEIKI KENTEISHIYO) 16-04-1982

## Beschreibung

Die Erfindung betrifft eine Schaltungsanordnung für die Kontrolle und Überwachung der Funktion eines elektronischen Elektrizitätszählers nach dem Oberbegriff des Patentanspruchs 1.

Ein elektronischer Elektrizitätszähler der oben bezeichneten Art ist in seinem prinzipiellen Aufbau und in seiner Funktion in der Zeitschrift "Technisches Messen atm", 1978, Heft 11, Seiten 407-411 beschrieben. Solche Zähler haben gegenüber elektromechanischen Zählern den Vorteil, daß sie bei verhältnismäßig geringem technischem Aufwand in einem weiten Lastbereich eine hohe Genauigkeit besitzen. Dem steht gegenüber, daß komplexe elektronische Baugruppen mit einer gewissen Fehler- bzw. Ausfallwahrscheinlichkeit behaftet sind.

Aus der GB-A-2 099 596 ist es bekannt, in einem Redundanzsystem die Signale zweier oder mehrerer nominal identischer Signalpfade miteinander zu vergleichen, um dadurch Fehler zu entdecken.

Patent Abstracts of Japan, Bd. 6, Nr. 141 (P-131) [1019], 30.07.82 & JP-A-5 763 461 offenbart ein Testverfahren für ein Wattmeter. Dabei vergleicht ein Mikrocomputer die mit seiner Mithilfe ermittelte mittlere Leistung mit der vom zu überwachenden Wattmeter gemessenen mittleren Leistung.

Die US-A-3 708 791 zeigt und beschreibt eine zeitlich gestaffelte Überwachung redundanter Signale, bei der unzulässige Abweichungen der Signale voneinander ein Hinweissignal erzeugen, das einer logischen Verknüpfungsschaltung zugeführt wird. Mit dieser Verknüpfungsschaltung wird erreicht, daß nicht sofort sondern in Abhängigkeit von weiteren vorhandenen Hinweissignalen eine Fehleranzeige erzeugt wird.

Aus der CH-A-653 778 ist eine Schaltungsanordnung zur Fünktionsüberwachung eines elektronischen Elektrizitätszählers bekannt. Dieser Zähler besitzt Überwachungsschaltkreise, die jeweils einzelnen Funktionsblöcken der elektronischen Schaltungsanordnung zugeordnet sind und bei einem Ausfall eines dieser Funktionsblöcke eine Störungsmeldung abgeben.

Es kann nun vorkommen, daß Funktionsblöcke oder einzelne Bauelemente einer solchen elektronischen Schaltungsanordnung nicht völlig ausfallen, sondern mit geänderten Parametern, also fehlerhaft, weiterarbeiten. Bei einer Ausstattung des Überwachungssystems der vorgenannten Art mit Grenzwertmeldern, die oberhalb oder unterhalb eines bestimmten Signalpegels ein Fehlersignal abgeben, muß sich dieses am gesamten Lastbereich des elektronischen Zählers orientieren, d.h. das Überwachungssystem kann erst dann ansprechen, wenn der normale Lastbereich unter- oder überschritten wird. Dies bedeutet, daß Fehler an der Schaltungsanordnung, deren Bandbreite die Grenzen des normalen Lastbereiches nicht überschreitet, von solchen Überwachungseinrichtungen nicht gemeldet werden. Dies kann sich im Laufe der Zeit zu erheblichen Gebührenfehlberechnungen summieren.

Der Erfindung liegt demzufolge die Aufgabe zugrunde, einen elektronischen Elektrizitätszähler mit Kontroll- und Überwachungsschaltkreisen so auszugestalten, daß auch solche Fehlfunktionen der elektronischen Schaltkreise zu einer Störungsmeldung führen, die sich innerhalb des normalen Lastbereiches des Zählers bewegen.

Diese Aufgabe wird durch die im Patentanspruch 1 angegebene Erfindung gelöst. Dadurch ist erreicht, daß mit verhältnismäßig einfachen und preiswerten elektronischen Mitteln neben einer Ausfallkontrolle elektronischer Bauelemente und Baugruppen gleichzeitig eine Fehlerkontrolle und in gewissem Umfang auch eine Fehlerortung möglich sind.

In einer Weiterbildung der Erfindung gemäß Patentanspruch 3 kann der maximal zulässige Fehlerzahlenwert durch eine von der dem Netz entnommenen Leistung abhängige Steuergröße beeinflußt werden. Dadurch ist es möglich, den Fehlerzahlenwert als prozentual von der Leistung abhängige Größe anstelle eines Absolutwertes der Überwachung zugrundezulegen.

Nach den Weiterbildungen gemäß den Patentanspruchen 4, 5 und 6 können auch die Stromwandler im Rahmen verschiedener Schaltungsanordnungen in die Fehlerüberwachung einbezogen werden.

Weitere Einzelheiten der Erfindung werden anhand von Ausführungsbeispielen im folgenden näher erläutert. Es zeigen:
- FIG 1: die prinzipielle Funktionsweise der erfindungsgemäßen Schaltungsanordnung;
- FIG 2: das Blockschaltbild eines einzelnen Zählers mit dem Zählerteil und dem Kontroll- und Vergleichsteil;
- FIG 3: die erfindungsgemäße Schaltungsanordnung für einen Doppelzähler mit zusätzlicher Funktionsüberwachung der kompensierten Stromwandler des Doppelzählers;
- FIG 4: eine Schaltungsanordnung gemäß FIG 3 in einer anderen Ausführungsform für die Stromwandlerüberwachung; und
- FIG 5: eine weitere Ausführungsform der Stromwandlerüberwachung einer Doppelzähleranordnung gemäß FIG 3.

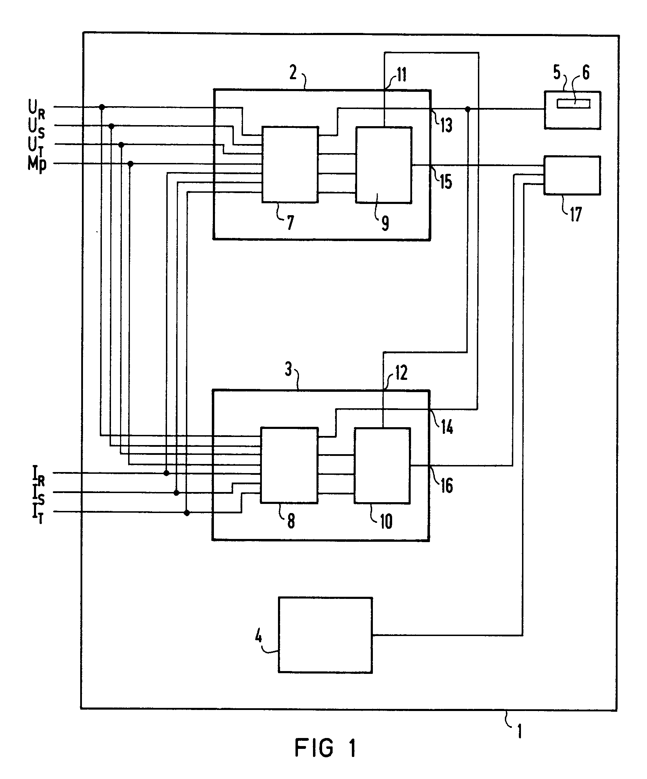

Gemäß FIG 1 sind zwei Zählerbaugruppen 2, 3 mit einem Netzteil 4, einem Zählwerk 5 sowie einer Anzeigevorrichtung 6 in einem gemeinsamen Zählergehäuse 1 untergebracht. Die Zählerbaugruppen enthalten je einen Zählerschaltkreis 7, 8 sowie je einen Kontroll- und Überwachungsschaltkreis 9, 10. Den Zählerbaugruppen 2, 3 sind die den drei Netzphasen U_{R}, U_{S}, U_{T} entsprechenden Spannungen sowie die von den nicht dargestellten Stromwandlern erzeugten, den in den Phasenleitungen fließenden Strömen I_{R}, I_{S}, I_{T} entsprechenden Meßspannungen und außerdem der Nulleiter Mₚ zugeführt. Jede Zählerbaugruppe besitzt darüber hinaus einen Kontrolleingang 11, 12 sowie einen Signalausgang 13 bzw. 14 für die Impulse des Zählwerkes 5 und schließlich einen Fehlersignalausgang 15 bzw. 16 für die Fehlersignalanzeige 17.

Die Zählerbaugruppen 2 und 3 können auch als integrierte Schaltkreise ausgeführt sein.

Dabei ist der Ausgang 13 der Zählerbaugruppe 2 sowohl mit dem Zählwerk 5 wie mit dem Kontrolleingang 12 der Zählerbaugruppe 3; der Ausgang 14 der Zählerbaugruppe 3 mit dem Kontrolleingang 11 der Zählerbaugruppe 2; der Fehlerausgang 15 der Zählerbaugruppe 2 und der Fehlerausgang 16 der Zählerbaugruppe 3 sowie das Netzteil 4 mit der Fehlersignalanzeige 17 verbunden.

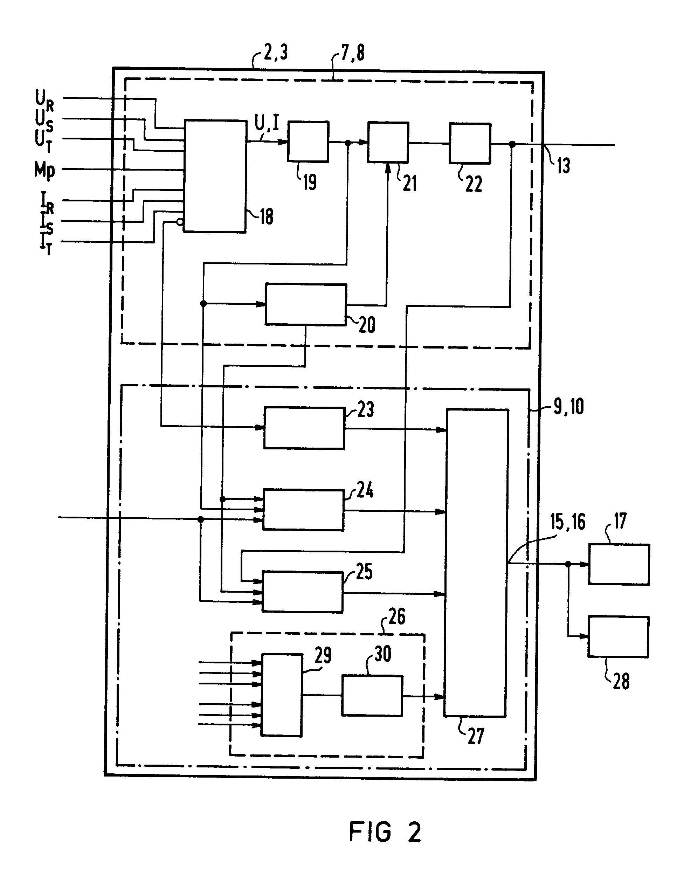

In FIG 2 ist der Aufbau einer der Zählerbaugruppen 2 bzw. 3 in Form eines Blockschaltbildes dargestellt. Der Zählerschaltkreis 7 bzw. 8 besitzt den bekannten Aufbau mit dem Multiplizierer 18, dem Quantisierer 19, der Impulsabstandskontrolle 20, der Anlaufsperre 21 und dem Frequenzteiler 22. Das Funktionsprinzip eines derart aufgebauten elektronischen Elektrizitätszählers ist aus der eingangs genannten Druckschrift bekannt und bedarf daher keiner näheren Erläuterung.

Der Kontroll- und Überwachungsschaltkreis 9 bzw. 10 ist ebenfalls als Blockschaltbild dargestellt und umfaßt eine Frequenzkontrollstufe 23, eine Gleichlaufkontrollstufe 24, eine Grobkontrollstufe 25, eine Stromwandlerkontrollstufe 26 und eine Verknüpfungslogik 27.

Die Frequenzkontrollstufe 23 überwacht die Periodendauer des Dreiecksgenerators des Multiplizierers 18; die Gleichlaufkontrollstufe 24 vergleicht die Zählwerkimpulse am Ausgang des Frequenzteilers 22 des jeweils anderen Zählerschaltkreises mit den höherfrequenten Impulsen am Ausgang des Quantisierers 19 des eigenen Zählerschaltkreises und registriert mit Hilfe eines Vor-/Rückwärtszählers die jeweiligen Impulszahldifferenzen abwechselnd in der positiven und in der negativen Zählrichtung; die Grobkontrollstufe prüft, ob nach Überschreiten eines unteren Belastungsgrenzwertes von beiden Zählerschaltkreisen 7, 8 innerhalb bestimmter Grenzen Zählwerkimpulse abgegeben werden; die Stromwandlerkontrollstufe 26 überprüft die Funktionsfähigkeit der kompensierten Stromwandler auf unzulässige Abweichungen durch deren zyklische Überwachung und schließlich überwacht die Verknüpfungslogik 27 die vorgenannten Stufen auf Fehlersignale und erzeugt beim Auftreten eines solchen Signals an ihrem Kontrollausgang 15 bzw. 16 ein Meldesignal und übermittelt dies an die Fehlersignalanzeige 17 und/oder eine übergeordnete Meldestelle 28.

Im einzelnen erfüllen die vorgenannten Stufen folgende Funktionen:
Die Frequenzkontrollstufe 23 überwacht die Periodendauer des Dreiecksgenerators des Time-Division-Multiplizierers 18 in der Weise, daß ein Meldesignal abgegeben wird, wenn die normalerweise konstante Frequenz dieses Generators einen festgelegten Toleranzbereich überschreitet. Dabei besteht gleichzeitig die Möglichkeit, den Aussteuerungsbereich des Multiplizierers in der Weise zu überwachen, daß bei Über- oder Unterschreiten minimaler oder maximaler Werte des von der gemessenen elektrischen Leistung abhängigen Impulsdauer-Impulspausen-Verhält nisses am Ausgang des Multiplizierers ein Meldesignal an die Verknüpfungslogik 27 abgegeben wird.

Die Gleichlaufkontrollstufe 24 vergleicht die am Ausgang des Quantisierers 19 des jeweils eigenen Zählerschaltkreises auftretenden Impulse mit den am Ausgang des Frequenzteilers 22 auftretenden niederfrequenteren Impulsen des Zählwerk-Signalausgangs 13 des jeweils anderen Zählerschaltkreises. Dazu besitzt die Gleichlaufkontrollstufe 24 einen Vor- und Rückwärtszähler. In diesen werden abwechselnd zu den Impulsen des Zählwerk-Signalausgangs 13 des jeweils anderen Zählerschaltkreises die Ausgangsimpulse des Quantisierers 19 des jeweils eigenen Zählerschaltkreises positiv und negativ eingezählt. Da zwischen den Impulsen des Zählwerk-Signalausgangs 13 und den Quantisiererimpulsen ein exaktes Teilerverhältnis besteht, kann aus dem jeweiligen Zählerstand bereits nach wenigen Impulsen des Zählwerk-Signalausgangs 13 eine Abweichung in der Meßgenauigkeit der beiden den jeweiligen Zählerschaltkreisen zugeordneten Funktionsstufen zahlenmäßig abgelesen werden. Wird dabei ein vorgegebener, exakt einstellbarer maximal zulässiger Fehler überschritten, so gibt die Gleichlaufkontrollstufe ein Meldesignal an die Verknüpfungslogik 27 ab. Diese Überwachung ist unabhängig von der jeweils gemessenen Netzbelastung. Zusätzlich ist nun die Gleichlaufkontrollstufe 24 mit der Impulsabstandskontrolle 20 des eigenen Zählschaltkreises 7, 8 verbunden. Daher besitzt die Gleichlaufkontrollstufe 24 eine Information über die jeweils vorliegende Netzbelastung. Diese zusätzliche Information kann dazu benutzt werden, den maximal zulässigen Fehler belastungsabhängig vorzugeben bzw. bei Unterschreiten eines bestimmten Belastungswertes, bei dem ohnehin die Anlaufsperre 21 in Funktion tritt, diese Kontrolle auszuschalten.

Die Grobkontrollstufe 25 stellt sicher, daß nach dem Überschreiten eines von der Anlaufsperre 21 festgelegten unteren Belastungswertes beide Zählerschaltkreise 7, 8 innerhalb eines Toleranzbereiches Impulse an das Zählwerk 5 abgeben. Wird dieser Toleranzbereich überschritten, wozu selbstverständlich auch der völlige Ausfall der Impulse für das Zählwerk 5 eines Zählerschaltkreises gehört, wird ein Fehlersignal an die Verknüpfungslogik 27 abgegeben.

Die Stromwandlerkontrollstufe 26 besteht aus einem Multiplexer 29 und einem Schwellwertschalter 30. Der Multiplexer 29 ist mit verschiedenen Schaltungspunkten der Eingangsstromkreise des Multiplizierers 18 verbunden und kann diese zyklisch überwachen. Bei Über- oder Unterschreiten vorgegebener Werte spricht der Schwellwertschalter 30 an und erzeugt an seinem Ausgang ein Fehlersignal, welches der Verknüpfungslogik 27 zugeführt wird. Die letztgenannte Überwachung ermöglicht vor allem eine Funktionskontrolle der Stromwandler.

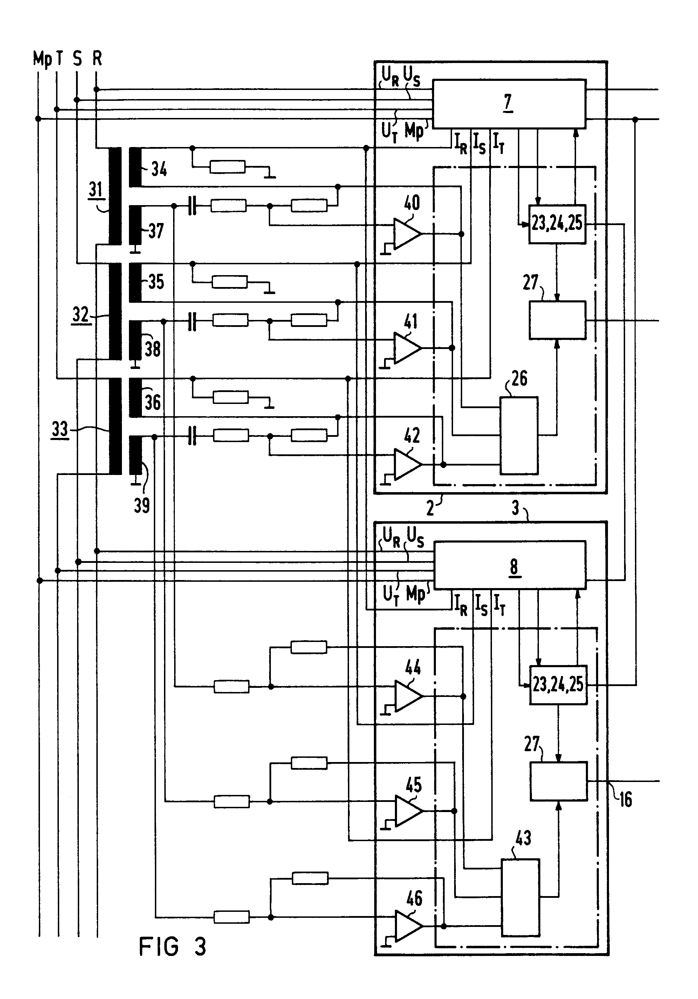

Dies kann auf unterschiedliche Weise geschehen, wie dies in den FIG 3, 4 und 5 im folgenden erläutert werden soll.

Gemäß FIG 3 sind die Stromeingänge der beiden Zählerschaltkreise 7, 8 über kompensierte Stromwandler mit dem zu überwachenden Netz R, S, T, Mₚ verbunden. Dabei handelt es sich um kompensierte Stromwandler, wie sie etwa in der Zeitschrift "Technisches Messen atm", 1978, Heft 11, Seite 408 unter Ziffer 2 beschrieben sind. Gemäß FIG 3 ist der dort dargestellte Drehstromzähler mit je einem kompensierten Stromwandler pro Phase 31, 32, 33 ausgestattet. Diese Stromwandler besitzen neben den Sekundärwicklungen 34, 35, 36 je eine Indikatorwicklung 37, 38, 39. Die Indikatorwicklungen 37, 38 und 39 sind mit je einem Kompensationsverstärker 40, 41, 42 verbunden, der eine Kompensationsspannung solcher Höhe erzeugt, daß die Stromwandler stets in einem linearen Bereich arbeiten. Um nun die Funktion dieser Stromwandler zu überwachen, sind diese in der üblichen Weise, d.h. mit ihrer kompensierten, vom Strom der jeweiligen Netzphase abhängigen Meßspannung, an die Stromeingänge I_{R}, I_{S}, I_{T} angeschlossen. Die Ausgänge der zugeordneten Kompensationsverstärker 40, 41, 42 sind mit dem Multiplexer 29 der Stromwandlerkontrollstufe 26 des Kontroll-und Überwachungsschaltkreises 9 der ersten Zählerbaugruppe 2 verbunden. Dem Multiplexer der Stromwandlerkontrollstufe 43 des Kontroll- und Überwachungsschaltkreises 10 der zweiten Zählerbaugruppe 3, der mit der Stromwandlerkontrollstufe 26 des Kontroll- und Überwachungsschaltkreises 9 der Zählerbaugruppe 2 identisch ist, werden demgegenüber nur die an den Indikatorwicklungen 37, 38, 39 auftretenden Spannungen über Indikatorspannungsverstärker 44, 45, 46 zugeführt. Dabei können die Kompensationsverstärker 40, 41, 42 und die Indikatorspannungsverstärker 44, 45, 46 identische Bauelemente sein.

Wenn ein Fehler im System Stromwandler/Verstärker vorliegt, so äußert sich dies durch einen Spannungsanstieg an der jeweiligen Indikatorwicklung. Dies führt zu einem Spannungsanstieg auch am Ausgang der Indikatorspannungsverstärker 44, 45, 46. Einen solchen Spannungsanstieg erkennt der Schwellwertschalter 30 der Stromwandlerkontrollstufe 43 als Fehler und er erzeugt demzufolge ein Fehlersignal am Ausgang der Stromwandlerkontrollstufe 43.

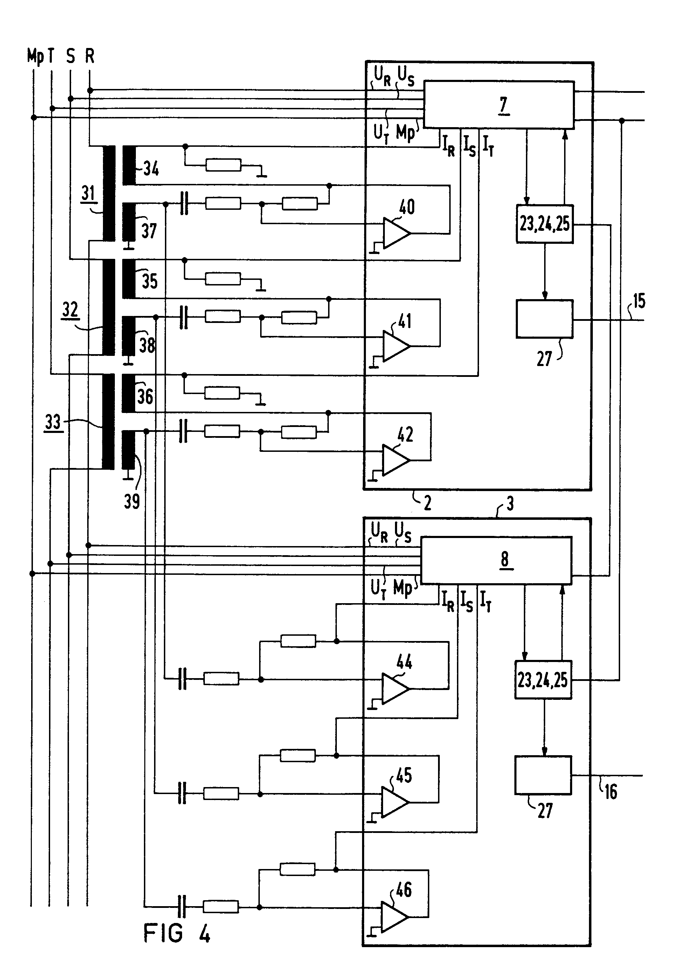

Eine weitere, in FIG 4 dargestellte Möglichkeit der Funktionskontrolle der Stromwandler 31, 32, 33 besteht darin, die Indikatorspannungsverstärker 44, 45, 46 in gleicher Weise wie die Kompensationsverstärker 40, 41, 42 an die Indikatorwicklungen anzuschließen. Dabei treiben nur die Kompensationsverstärker 40, 41, 42 einen Kompensationsstrom durch die zugeordneten Sekundärwicklungen 34, 35, 36, während die Indikatorspannungsverstärker 44, ,45, 46 direkt an die Eingänge I_{R}, I_{S}, I_{T} des Zählerschaltkreises 8 der Zählerbaugruppe 3 angeschlossen sind. Das Auftreten eines Fehlers im System Stromwandler/Verstärker wird in diesem Falle wegen der Abweichungen des Normalverhältnisses der stromproportionalen Meßwertspannungen zwischen den beiden Zählerschaltkreisen 7, 8 von den zugeordneten Gleichlaufkontrollstufen 24 festgestellt und als Fehler an die Verknüpfungslogik 27 gemeldet. In dieser Schaltung können die Stromwandlerkontrollstufen 26 mit den Multiplexern 29 und den Schwellwertschaltern 30 in beiden Zählerbaugruppen 2, 3 entfallen.

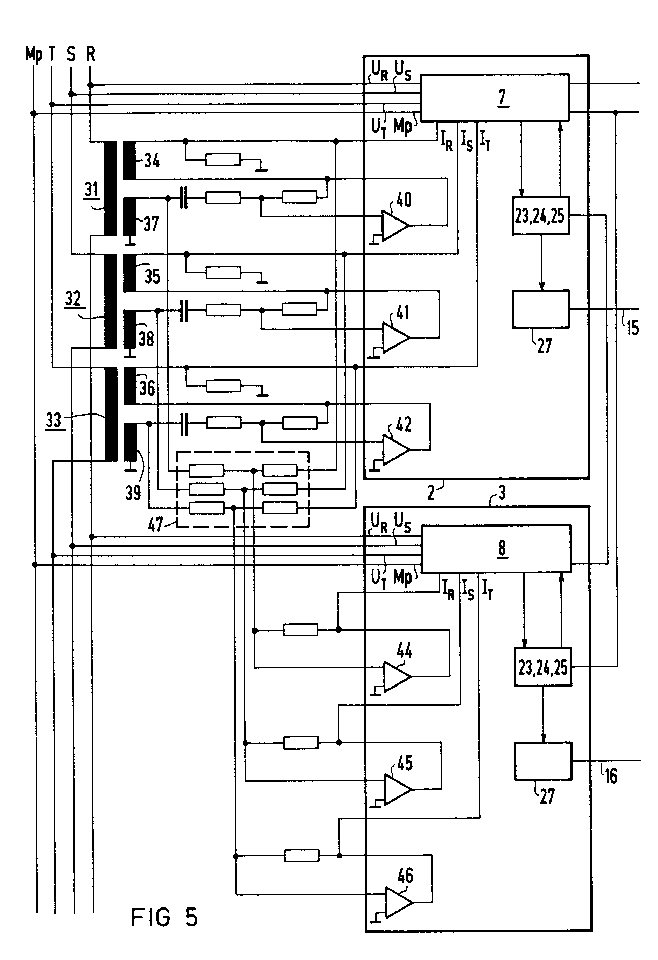

Eine dritte Möglichkeit der Stromwandlerüberwachung ist in FIG 5 dargestellt. Dabei sind die Indikatorspannungsverstärker 44, 45, 46 als Summationsverstärker beschaltet, die zum Ausgangssignal der Indikatorwicklungen über den ohmschen Spannungsteiler 47 jeweils einen kleinen Teil der Ausgangsspannung der zugeordneten Sekundärwicklungen addieren. Im übrigen entspricht die Schaltungsanordnung derjenigen nach FIG 4. Bei Auftreten eines Fehlers im System Stromwandler/Verstärker erhöht sich der Beitrag, der von der Sekundärwicklung kommt, was in gleicher Weise wie in der Schaltungsanordnung nach FIG 4 zu einer von der Gleichlaufkontrollstufe 24 ausgelösten Fehlermeldung führt.

Die Beschaltung der Verstärker 40, 41, 42 und 44, 45, 46 mit Widerständen und Kondensatoren entspricht dem üblichen Standard und bedarf keiner besonderen Erläuterung.

## Patentansprüche

1. Schaltungsanordnung für die Kontrolle und Überwachung der Funktion eines elektronischen Elektrizitätszählers (2, 3), der aus einem Spannungsmeßkreis zur Bildung eines der Netzspannung proportionalen elektrischen Signals und einem Strommeßkreis zur Bildung eines dem Netzstrom proportionalen elektrischen Signals, einem das Produkt aus den beiden Signalen bildenden elektronischen Multiplizierer (18), einem elektronischen Quantisierer (19) zur Bildung einer der ermittelten elektrischen Leistung proportionalen Impulsfrequenz, einem Anlaufsperrglied (21) zur Sperrung der jenigen Impulse des Quantisierers die in zeitlich größeren Abständen voneinander liegen, als es einer unteren, vorgegebenen Frequenzgrenze entspricht, sowie einem Frequenzteiler (22) zum Herunterteilen der Frequenz, mit der die Impulse vom Anlaufsperrglied (21) einem Impulszählwerk (5) zugeführt werden, in der Weise, daß die Anzeige des Zählwerkes (5) der dem Netz entnommenen elektrischen Arbeit in kWh entspricht, besteht, wobei die Schaltungsanordnung Kontroll- und Überwachungsschaltkreise (9, 10) für die Funktionen aller die elektrischen Signale umwandelnden Funktionsblöcke aufweist und die Kontroll- und Überwachungsschaltkreise (9, 10) mit einer Anzeigevorrichtung (17) verbunden sind, die beim Auftreten einer Störung anspricht und ein Kontrollsignal erzeugt, **dadurch gekennzeichnet,** daß der elektronische Elektrizitätszähler (2, 3) und die zugeordneten Kontroll- und Überwachungsschaltkreise (9, 10) doppelt vorhanden sind und daß die Kontroll- und Überwachungsschaltkreise Vergleichsstufen (23, 24, 25) enthalten, die die Ausgangsimpulse zum Zählwerk (5) des jeweils anderen Zählers (2, 3) mit den Impulsen der überwachten Funktionsblöcke (18, 19, 21, 22) des zugeordneten Zählers (2, 3) vergleichen und bei unzulässigen Abweichungen zwischen den verglichenen Signalen einer Verknüpfungslogik (27) für auftretende Fehlersignale ein Fehlersignal zuführen.

2. Schaltungsanordnung nach Anspruch 1, **dadurch gekennzeichnet,** daß die den elektronischen Zählern (2, 3) zugeordneten Kontroll- und Überwachungsschaltkreise gebildet sind:
- aus je einer Frequenzkontrollstufe (23) für die Dreiecksgeneratoren der Multiplizierglieder (18), die bei Überschreiten einer maximalen oder Unterschreiten einer minimalen Periodendauer ein Fehlersignal abgibt;
- aus je einer Gleichlaufkontrollstufe (24), die die Zählwerkimpulse des jeweils anderen Zählers mit den vom Quantisierer (19) des eigenen Zählers stammenden höherfrequenten Impulsen vergleicht, indem sie diese abwechselnd positiv oder negativ auszählt und bei Überschreiten eines vorgegebenen positiven oder Unterschreiten eines vorgegebenen negativen Fehlerzahlenwertes ein Fehlersignal abgibt;
- aus je einer Grobkontrollstufe (25), die die Zählwerkimpulse des jeweils anderen Zählers mit den Zählwerkimpulsen des eigenen Zählers vergleicht und beim Über- oder Unterschreiten festgelegter Abweichungen zwischen den Signalen beider Zähler ein Fehlersignal abgibt;
- aus je einer Stromwandlerkontrollstufe (26; 43) zur Überwachung der Höhe der von kompensierten Stromwandlern (31, 32, 33) erzeugten Ausgangssignale, die bei positiver oder negativer Abweichung vorgegebener Signalwerte ein Fehlersignal abgibt; sowie
- aus der jeweiligen Verknüpfungslogik (27), die die Fehlersignale überwacht und bei Zusammentreffen bestimmter Fehlersignale ein Schaltsignal etwa zum Unterbrechen der Zählerstromkreise oder ein Meldesignal an eine übergeordnete Meldestelle abgibt.

3. Schaltungsanordnung nach Anspruch 2, **dadurch gekennzeichnet,** daß jeder Gleichlaufkontrollstufe (24) als zusätzliches Signal die von einer zugeordneten Impulsabstandskontrollstufe (20) ermittelte Periodendauer des Dreiecksgenerators des Multiplizierers (18) zugeführt wird, die der jeweils dem Netz entnommenen elektrischen Leistung proportional ist, und daß die Gleichlaufkontrollstufe (24) daraus eine leistungsabhängige Steuergröße für den maximal zulässigen Fehlerzahlenwert in Abhängigkeit von der dem Netz entnommenen Leistung bildet.

4. Schaltungsanordnung nach Anspruch 2 oder 3, **dadurch gekennzeichnet,** daß die Stromwandlerkontrollstufen (43) aus je einem Multiplexer (29) mit nachgeschaltetem Schwellwertschalter (30) zur zyklischen Überwachung der Höhe der von den jeder Netzphase zugeordneten kompensierten Stromwandlern (31, 32, 33) erzeugten Meßspannungen gebildet sind und daß dem Multiplexer (29) des Kontroll- und Überwachungsschaltkreises (9, 10) des ersten Zählers (2) die Meßspannungen der Sekundärwicklungen (34, 35, 36) der kompensierten Stromwandler (31, 32, 33) und dem Multiplexer (29) des Kontroll- und Überwachungsschaltkreises (9, 10) des zweiten Zählers (3) die Meßspannungen nur der Indikatorwicklungen (37, 38, 39) der kompensierten Stromwandler (31, 32, 33) zugeführt sind.

5. Schaltungsanordnung nach Anspruch 2 oder 3, **dadurch gekennzeichnet,** daß zur Stromwandlerkontrolle im Zähler (2, 3) eine Verstärkungs-Schaltungsanordnung (40, 41, 42 bzw. 44, 45, 46) vorgesehen ist, der bei dem einen Zähler (2) die kompensierten Meßspannungen der kompensierten Stromwandler (31, 32, 33) und bei dem anderen Zähler (3) nur die von den Indikatorwicklungen (37, 38, 39) der kompensierten Stromwandler (31, 32, 33) erzeugten Meßspannungen zugeführt sind.

6. Schaltungsanordnung nach Anspruch 2 oder 3, **dadurch gekennzeichnet,** daß zur Stromwandlerkontrolle im Zähler (2, 3) eine Verstärkungs-Schaltungsanordnung (40, 41, 42 bzw. 44, 45, 46) vorgesehen ist, der bei dem einen Zähler (2) für jede Netzphase die jeweilige kompensierte Meßspannung des zugehörigen kompensierten Stromwandlers (31, 32, 33) und bei dem anderen Zähler (3) für jede Netzphase die Summe aus der Meßspannung der jeweiligen Indikatorwicklung (37, 38, 39) und einem Bruchteil der Meßspannung der zugeordneten Sekundärwicklung (34, 35, 36) des jeweiligen kompensierten Stromwandlers (31, 32, 33) zugeführt sind.

## Claims

1. Circuit arrangement for the control and monitoring of the function of an electronic electricity meter (2, 3) which consists of a voltage measuring circuit for the formation of an electrical signal proportional to the system voltage and a current measuring circuit for the formation of an electrical signal proportional to the line current, an electronic multiplier (18) forming the product from the two signals, an electronic quantizer (19) for the formation of a pulse frequency proportional to the determined electrical power, a starting blocking element (21) for blocking those pulses of the quantizer which lie at temporally greater intervals from one another than corresponds with a lower, specified frequency limit, as well as a frequency divider (22) for dividing down the frequency with which the pulses from the starting blocking element (21) are supplied to a pulse counting mechanism (5), in such a way that the display of the counting mechanism (5) corresponds to the electrical work drawn from the system in kWh, whereby the circuit arrangement has control and monitoring switching circuits (9, 10) for the functions of all function blocks converting the electrical signals, and the control and monitoring switching circuits (9, 10) are connected to a display device (17) which operates upon the occurrence of a disturbance and generates a control signal, characterized in that the electronic electricity meter (2, 3) and the associated control and monitoring switching circuits (9, 10) are present twice and in that the control and monitoring switching circuits contain comparison stages (23, 24, 25) which compare the output pulses to the counting mechanism (5) of the respective other meter (2, 3) with the pulses of the monitored function blocks (18, 19, 21, 22) of the associated meter (2, 3) and, with unacceptable differences between the compared signals, supply an error signal to a connection logic element (27) for error signals which occur.

2. Circuit arrangement according to claim 1, characterized in that the control and monitoring switching circuits associated with the electronic meters (2, 3) are formed:
- from, in each case, a frequency control stage (23) for the triangular generators of the multiplier elements (18) which, upon exceeding a maximum or falling short of a minimum period, delivers an error signal;
- from, in each case, a synchronous control stage (24) which compares the counting-mechanism pulses of the respective other meter with the pulses of higher frequency originating from the quantizer (19) of the specific meter, in that it counts them alternately positively or negatively and, upon exceeding a specified positive or falling short of a specified negative error numerical value, delivers an error signal;
- from, in each case, a coarse control stage (25) which compares the counting-mechanism pulses of the respective other meter with the counting-mechanism pulses of the specific meter and, upon exceeding or falling short of determined differences between the signals of both meters, delivers an error signal;
- from, in each case, a current-converter control stage (26, 43) for monitoring the level of the output signals generated by compensated current converters (31, 32, 33), which, upon positive or negative difference of specified signal values, delivers an error signal; and
- from the respective connection logic (27) which monitors the error signals and with the coincidence of certain error signals delivers a switching signal approximately for the interruption of the meter current circuits or an indicating signal to a higher indicating point.

3. Circuit arrangement according to claim 2, characterized in that to each synchronous control stage (24) there is supplied as an additional signal the period of the triangular generator of the multiplier (18) determined by an associated pulse interval control stage (20), the period being proportional to the electrical power drawn in each case from the system, and in that the synchronous control stage (24) forms therefrom a power-dependent controlled variable for the maximum admissible error numerical value in dependence upon the power drawn from the system.

4. Circuit arrangement according to claim 2 or 3, characterized in that the current-converter control stages (43) are formed from in each case a multiplexer (29) with a subsequently connected threshold-value switch (30) for the cyclical monitoring of the level of the measured voltages generated by the compensated current converters (31, 32, 33) associated with each network phase and in that there are supplied to the multiplexer (29) of the control and monitoring switching circuit (9, 10) of the first meter (2) the measured voltages of the secondary windings (34, 35, 36) of the compensated current converters (31, 32, 33) and to the multiplexer (29) of the control and monitoring switching circuit (9, 10) of the second meter (3) the measured voltages only of the indicator windings (37, 38, 39) of the compensated current converters (31, 32, 33).

5. Circuit arrangement according to claim 2 or 3, characterized in that there is provided for the current-converter control in the meter (2, 3) an amplification circuit arrangement (40, 41, 42 or 44, 45, 46), to which there are supplied with the one meter (2) the compensated measured voltages of the compensated current converters (31, 32, 33) and with the other meter (3) only the measured voltages generated by the indicator windings (37, 38, 39) of the compensated current converters (31, 32, 33).

6. Circuit arrangement according to claim 2 or 3, characterized in that for the current-converter control in the meter (2, 3) an amplification circuit arrangement (40, 41, 42 or 44, 45, 46) is provided, to which there is supplied with the one meter (2) for each network phase the respective compensated measured voltage of the appertaining compensated current converter (31, 32, 33) and with the other meter (3) for each network phase the sum from the measured voltage of the respective indicator winding (37, 38, 39) and a fraction of the measured voltage of the associated secondary winding (34, 35, 36) of the respective compensated current converter (31, 32, 33).

## Revendications

1. Montage pour le contrôle et la surveillance du fonctionnement d'un compteur d'électricité électronique (2, 3), qui est constitué par un circuit voltmétrique servant à former un signal électrique proportionnel à la tension du réseau, et un circuit ampèremétrique servant à former un signal électrique proportionnel au courant du réseau, par un multiplicateur électronique (18) qui forme le produit de ces deux signaux, un quantificateur électronique (19) pour former une fréquence d'impulsions proportionnelle à la puissance électrique déterminée, un circuit de blocage du démarrage (21) pour bloquer les impulsions du quantificateur, qui sont séparées par des intervalles de temps supérieurs à ce qui correspond à une limite de fréquence inférieure prédéterminée, ainsi qu'un diviseur de fréquence (22) servant à diviser la fréquence avec laquelle les impulsions sont envoyées par le circuit de blocage du démarrage (21) à une unité de comptage d'impulsions (5), de telle sorte que l'affichage fourni par l'unité de comptage (5) correspond au travail électrique en kWh prélevé du réseau, et dans lequel le montage comporte des circuits (9,10) de contrôle et de surveillance pour les fonctions de tous les blocs fonctionnels convertissant les signaux électriques, et les circuits de contrôle et de surveillance (9,10) sont raccordés à un dispositif d'affichage (17), qui répond lors de l'apparition d'une perturbation et produit un signal de contrôle, caractérisé par le fait que le compteur d'électricité électronique (2,3) et les circuits associés de contrôle et de surveillance (9,10) sont prévus en double et que les circuits de contrôle et de surveillance comportent des étages comparateurs (23,24,25), qui comparent les impulsions de sortie envoyées à l'unité de comptage (5) de l'autre compteur respectif (2,3) aux impulsions des blocs fonctionnels contrôlés (18,19,21,22) du compteur associé (2,3) et, en cas d'écarts admissibles entre les signaux comparés, envoient un signal d'erreur à un circuit logique combinatoire (27) pour les signaux d'erreur qui apparaisent.

2. Montage suivant la revendication 1, caractérisé par le fait que les circuits de contrôle et de surveillance associés aux compteurs électroniques (2,3) sont formés par :
- respectivement un étage de commande de fréquence (23) pour les générateurs de signaux triangulaires des circuits multiplicateurs (18), qui délivre un signal d'erreur lors du dépassement par valeurs supérieures d'une durée de période maximale ou du dépassement par valeurs inférieures d'une durée de période minimale;
- respectivement un étage de contrôle de synchronisme (24), qui compare les impulsions de l'unité de comptage de l'autre compteur respectif aux impulsions à fréquence supérieure qui proviennent du quantificateur (19) du compteur proprement dit, par le fait que cet étage compte alternativement dans le sens progressif ou négatif ces impulsions et délivre un signal d'erreur lors du dépassement par valeurs supérieures d'une valeur chiffrée d'erreur positive prédéterminée ou lors du dépassement par valeurs inférieures d'une valeur chiffrée d'erreur négative prédéterminée;
- respectivement un étage de contrôle approximatif (25), qui compare les impulsions de l'unité de comptage de l'autre compteur respectif aux impulsions de l'unité de comptage du compteur particulier et délivre un signal d'erreur lors du dépassement par valeurs supérieures ou par valeurs inférieures d'écarts prédéterminés entre les signaux des deux compteurs;
- respectivement un étage (26;43) de contrôle de transformateurs d'intensité pour contrôler l'intensité des signaux de sortie produits par des transformateurs d'intensité compensés (31,32,33), qui délivre un signal d'erreur dans le cas d'un écart positif ou négatif de valeurs prédéterminées de signaux; ainsi que par
- le circuit logique combinatoire respectif (27), qui contrôle les signaux d'erreur et, en cas de coïncidence de signaux d'erreur déterminés, envoie un signal de commutation par exemple pour interrompre les circuits des compteurs ou envoie un signal de signalisation à un poste de signalisation de rang supérieur.

3. Montage suivant la revendication 2, caractérisé par le fait qu'à chaque étage de contrôle de synchronisme (24) est envoyée, en tant que signal supplémentaire, la durée de période du générateur de signaux triangulaires du multiplicateur (18), déterminée par un étage associé de contrôle d'écarts entre impulsions (20) et qui est proportionnelle à la puissance électrique respectivement prélevée du réseau, et que l'étage de contrôle de synchronisme (24) forme, à partir de là, une grandeur de commande qui dépend de la puissance, pour la valeur chiffrée d'erreur maximale admissible en fonction de la puissance prélevée du réseau.

4. Montage suivant la revendication 2 ou 3, caractérisé par le fait que les étages (43) de commande des transformateurs d'intensité sont constitués respectivement par un multiplexeur (29) en aval duquel est branché un commutateur à valeur de seuil (30) pour le contrôle cyclique de l'amplitude des tensions de mesure produites par les transformateurs d'intensité compensés (31,32,33), associés à chaque phase du réseau, et qu'au multiplexeur (29) du circuit de contrôle et de surveillance (9,10) du premier compteur (2) sont envoyées les tensions de mesure des enroulements secondaires (34,35,36) des transformateurs d'intensité compensés (31,32,33) et qu'au multiplexeur (29) du circuit de contrôle et de surveillance (9,10) du second compteur (3) sont envoyées les tensions de mesure uniquement des enroulements indicateurs (37,38,39) des transformateurs d'intensité compensés (31,32,33).

5. Montage suivant la revendication 2 ou 3, caractérisé par le fait que pour le contrôle des transformateurs d'intensité dans le compteur (2,3), il est prévu un montage amplificateur (40,41,42 ou 44,45,46), auquel sont envoyées, dans le cas d'un compteur (2), des tensions de mesure compensées des transformateurs d'intensité compensés (31,32,33) et, dans le cas de l'autre compteur (3), uniquement les tensions de mesure produites par les enroulements indicateurs (37,38,39) des transformateurs d'intensité compensés (31,32,33).

6. Montage suivant la revendication 2 ou 3, caractérisé par le fait que pour le contrôle des transformateurs d'intensité dans le compteur (2,3), il est prévu un montage amplificateur (40,41,42 ou 44,45,46), auquel sont envoyées, dans le cas d'un compteur (2), pour chaque phase du réseau, la tension de mesure respective compensée du transformateur d'intensité compensée associé (31,32,33) et, dans le cas de l'autre compteur (3), pour chaque phase du réseau, la somme formée de la tension de mesure de l'enroulement indicateur respectif (37,38,39) et d'une fraction de la tension de mesure de l'enroulement secondaire associé (34,35,36) du transformateur d'intensité respectif compensé (31,32,33).
